# EUROPEAN PATENT APPLICATION

(11) **EP 4 723 480 A1**
(43) Date of publication of application: **08.04.2026**
(21) Application number: 25206954.7
(22) Date of filing: 06.10.2025
(51) Int. Cl.: H03K 5/07, H03B 5/12

(54) **DUTY CYCLE CORRECTION OF PHASE INTERPOLATOR OUTPUT**

(30) Priority: 07.10.2024 US 202418908474
(71) Applicant: Avago Technologies International Sales Pte. Limited, Singapore 768923 (SG)
(72) Inventor: Guha Roy, Ankur, Mission Viejo, 92691 (US); Shim, Yonghyun, Irvine, 92620 (US); Lu, Dongtian, Irvine, 92620 (US); Huang, Zhi Chao, Irvine, 92620 (US); Zhang, Heng, Irvine, 92620 (US); Nazemi, Ali, Aliso Viejo, 92656 (US); Cao, Jun, Irvine, 92620 (US)
(74) Representative: Dilg, Haeusler, Schindelmann Patentanwaltsgesellschaft mbH

(57) **Abstract**

An example phase interpolator in an integrated circuit (IC) includes: a first circuit including a transistor pair and a current source, the transistor pair including a first transistor coupled between a first node and the current source, and second transistor coupled between a second node and the current source, a gate of the first transistor configured to receive a first clock signal and a gate of the second transistor configured to receive a second clock signal that is antiphase with the first clock signal; a load circuit including a first inductor coupled between the first node and the second node and a resistor coupled between a voltage source and a center terminal of the first inductor; and a second circuit coupled between the center terminal of the first inductor and an alternating current (AC) ground, the second circuit tuned to conduct a second harmonic of the first clock signal.

## Description

### BACKGROUND

Recent growth in data center and cloud processing has resulted in new research in the field of communication links with high data rates. An example includes copper cable-based serializer/de-serializer (SerDes) links for short distance rack-to-rack communication. Another example includes coherent optical-based links for moderate to long distance applications (e.g., between data centers). A SerDes may be a circuit that can serialize and de-serialize data used in device-to-device communication. Both a SerDes and an optical link can include a transceiver for transmitting and receiving signals from a transmission medium. A transceiver may be a circuit that can both transmit and receive signals. A transceiver can include a transmitter and a receiver. A transmitter may be a circuit that transmits a signal through a transmission medium. A receiver may be a circuit that observes a signal propagating through a transmission medium.

Both transmitters and receivers can use high-precision, multi-phase clock signals in operation. A clock signal may be a signal that toggles between two states at a frequency (referred to as a high state and a low state). Multi-phase clock signals may be multiple clock signals at the same frequency that differ in phase. The frequency of a clock signal may be the number of oscillations per unit of time. The phase of a clock may quantify the time-instant when the clock crosses a particular value. Phase can be measured as a phase angle. A clock generator may be a circuit that generates clock signal(s). For example, a clock generator can generate four clock signals of the same frequency successively differing in phase by 90 degrees. Four-phase clock generation can include an in-phase clock signal (Φₒ + 0° phase), a quadrature clock signal (Φₒ + 90° phase), a clock signal (Φₒ + 180° phase) that is antiphase with the in-phase clock signal, and a clock signal (Φₒ + 270° phase) that is antiphase with the quadrature clock signal. Antiphase can be a difference of 180° between two phases. The quantity Φₒ can be any arbitrary phase angle. Assume Φₒ is zero for purposes of exposition.

A phase interpolator (PI) may be a circuit that receives multi-phase clock signals as input and generates clock signal(s) as output with phase(s) somewhere between the phases (e.g., interpolation) of the input clock signals by a value based on an input control code. For example, a PI can receive four-phase clock signals as input and generate four-phase clock signals as output, but each shifted by a selected phase angle, e.g., (0° + φ)-phase clock signal, (90° + φ)-phase clock signal, (180° + φ)-phase clock signal, and (270° + φ)-phase clock signal, where φ is the selected phase angle. Non-idealities in the PI can cause duty-cycle distortion (DCD) in each of the output clock signals. The duty cycle of a clock signal may be the percentage of time the clock signal is in the high state.

The presence of a DCD can affect performance of circuits that use the output clocks from a PI. A duty-cycle correction (DCC) circuit may be a circuit that mitigates or eliminates DCD in a clock signal. Each clock signal output from a PI can include a separate DCC to compensate for DCD. As the number of clock signals of different phases increases, so does the power and circuit area consumed by multiple DCCs used to compensate for DCD.

### SUMMARY

In an embodiment, a phase interpolator in an integrated circuit (IC) is described. The phase interpolator can include a first circuit including a transistor pair and a current source. The transistor pair can include a first transistor coupled between a first node and the current source, and second transistor coupled between a second node and the current source. A gate of the first transistor can be configured to receive a first clock signal and a gate of the second transistor can be configured to receive a second clock signal that is antiphase with the first clock signal. The phase interpolator can include a load circuit including a first inductor coupled between the first node and the second node and a resistor coupled between a voltage source and a center terminal of the first inductor. The phase interpolator can include a second circuit coupled between the center terminal of the first inductor and an alternating current (AC) ground, the second circuit tuned to conduct a second harmonic of the first clock signal.

In another embodiment, a phase interpolator in an integrated circuit (IC) is described. The phase interpolator can include a first current source and a second current source. The phase interpolator can include a first transistor pair including a first transistor coupled between a first node and the first current source, and a second transistor coupled between a second node and the first current source. The first transistor pair can be configured to output a first clock signal at the first node and a second clock signal at the second node, the second clock signal being antiphase with the first clock signal. The phase interpolator can include a second transistor pair including a third transistor coupled between a third node and the second current source, and a fourth transistor coupled between a fourth node and the second current source. The second transistor pair can be configured to output a third clock signal, which is in quadrature with the first clock signal, at the third node and a fourth clock signal at the fourth node, the fourth clock signal being antiphase with the third clock signal. The phase interpolator can include a first inductor coupled between the first and second nodes and a second inductor coupled between the third and fourth nodes. The phase interpolator can include a first resistor coupled between a voltage source a center terminal of the first inductor and a second resistor coupled between the voltage source and a center terminal of the second inductor. The phase interpolator can include a first network coupled between the center terminal of the first inductor and an alternating current (AC) ground. The phase interpolator can include a second network coupled between the center terminal of the second inductor and the AC ground.

In another embodiment, a clock distribution circuit in an integrated circuit (IC) is described. The clock distribution circuit can include a phase interpolator. The phase interpolator can include a first circuit including a transistor pair and a current source. The transistor pair can include a first transistor coupled between a first node and the current source, and second transistor coupled between a second node and the current source. A gate of the first transistor can be configured to receive a first clock signal and a gate of the second transistor configured to receive a second clock signal that is antiphase with the first clock signal. The phase interpolator can include a load circuit including a first inductor coupled between the first node and the second node and a first resistor coupled between a voltage source and a center terminal of the first inductor. The phase interpolator can include a second circuit coupled between the center terminal of the first inductor and an alternating current (AC) ground, the second circuit tuned to conduct a second harmonic of the first clock signal. The clock distribution circuit can include a third circuit coupled to the first node. The third circuit can include a first series of inverters, a second resistor coupled between an input and an output of a first inverter in the first series. The clock distribution circuit can include a fourth circuit coupled to the second node. The fourth circuit can include a second series of inverters, a third resistor coupled between an input and an output of a second inverter in the second series.

### BRIEF DESCRIPTION OF THE DRAWINGS

Fig. 1 is a block diagram depicting a communication circuit according to some embodiments.
Fig. 2A is a block diagram depicting clock distribution circuit according to some embodiments.
Fig. 2B is a block diagram depicting PI of the clock distribution circuit of Fig. 2A according to some embodiments.
Fig. 3 is a schematic diagram depicting a PI core according to some embodiments.
Fig. 4A is a schematic diagram depicting a CMOS converter according to some embodiments.
Fig. 4B is a schematic diagram depicting a model of the converter of Fig. 4A with distortion on the input clock signal.
Fig. 5A is a graph depicting amplitude versus duty cycle for the clock signal output from the converter of Fig. 4A without DCD compensation.
Fig. 5B is a graph depicting phase versus duty cycle for the clock signal output from the converter of Fig. 4A without DCD compensation.
Fig. 6 is a schematic diagram depicting a model of the PI core of Fig. 3 coupled to a load circuit and a harmonic trap according to embodiments.
Fig. 7A is a schematic diagram depicting harmonic trap according to some embodiments.
Fig. 7B is a side view of an IC in which the harmonic trap of Fig. 7A can be implemented according to some embodiments.
Fig. 7C is a hybrid physical layout and schematic view of a load circuit and harmonic trap of Fig. 7A according to some embodiments.
Fig. 7D is a hybrid physical layout and schematic view of load circuits and harmonic traps of a quadrature PI according to some embodiments.
Fig. 8A is a hybrid physical layout and schematic view of load circuits and harmonic traps of a quadrature PI according to further embodiments.
Fig. 8B is a side view of the physical layout shown in Fig. 8A according to some embodiments.
Fig. 9A is a hybrid physical layout and schematic view of load circuits and harmonic traps of a quadrature PI according to further embodiments.
Fig. 9B is a hybrid physical layout and schematic view of load circuits and harmonic traps of a quadrature PI according to further embodiments.
Fig. 10A is a schematic diagram depicting harmonic trap according to further embodiments.
Fig. 10B is a hybrid physical layout and schematic view of a load circuit and the harmonic trap of Fig. 10A according to further embodiments.
Fig. 11A is a hybrid physical layout and schematic view of a load circuit and the harmonic trap of Fig. 10A according to further embodiments.
Fig. 11B is a hybrid physical layout and schematic view of load circuits and harmonic traps of a quadrature PI according to further embodiments.
Fig. 12 is a hybrid physical layout and schematic view of load circuits and harmonic traps of a quadrature PI according to further embodiments.

### DETAILED DESCRIPTION

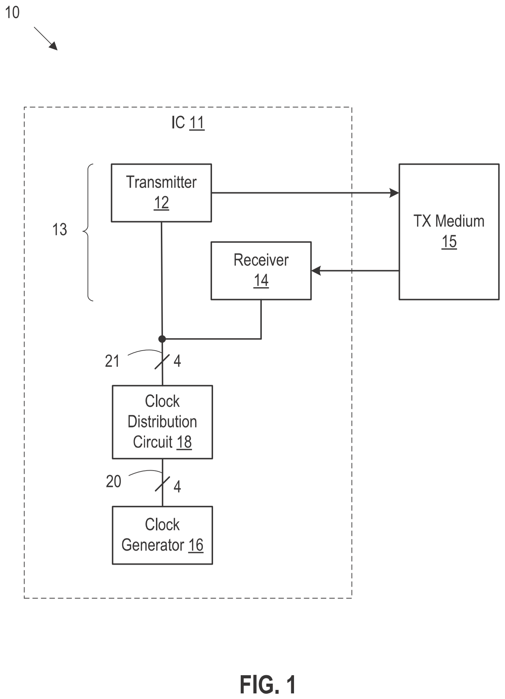

Fig. 1 is a block diagram depicting a communication circuit 10 according to some embodiments. Communication circuit 11 can include a transceiver 13 in an integrated circuit (IC) 11. An IC may be a set of circuits formed by a semiconductor material and conductive interconnect disposed on the semiconductor material. Conductive interconnect can be structures that form or electrically connect circuit elements. Various semiconductor materials and semiconductor fabrication processes are known for fabricating an IC. One skilled in the art can select among one or more such materials and processes based on the description of the examples and embodiments herein. The complementary metal-oxide-semiconductor (CMOS) fabrication process for forming integrated circuits on silicon is widely used and well-known. Accordingly, for purposes of clarity, various examples and embodiments are described below within the context of an IC formed using a CMOS fabrication process.

Transceiver 13 can include a transmitter 12 and a receiver 14. Transmitter 12 can transmit a signal to a transmission medium 15 (shown as TX medium 15). Receiver 14 can observe a signal from transmission medium 15. A transmission medium may be a physical pathway for propagating signals. Transmission medium 15 can be wireline (e.g., copper cabling, optical links, etc.) or wireless (e.g., over-the-air).

IC 11 includes a clock generator 16 and a clock distribution circuit 18. Clock generator 16 can be a phase-locked loop (PLL) or the like type of well-known circuit configured to generate clock signals. In some embodiments, clock generator 16 can generate four clock signals 20 that successively differ in phase by 90 degrees. Clock signals 20 can be sinusoidal signals having a common frequency and different phases. A sinusoidal signal may be a signal having a waveform based on sine or cosine functions.

A clock distribution circuit may be a circuit that provides clock signals to other circuits. Clock distribution circuit 18 can distribute clock signals 21 to transmitter 12 and receiver 14. Clock distribution circuit 18 can generate clock signals 21 by manipulating clock signals 20 output from clock generator 16. In some embodiments, clock distribution circuit 18 outputs four clock signals 21 that successively differ in phase by 90 degrees by manipulating clock signals 20. Clock signals 21 can be square-wave signals having a common frequency and different phases. A square-wave signal may be a signal having a non-sinusoidal waveform in which the amplitude repeatedly sharply rises to a maximum amplitude, remains at the maximum amplitude for a time, sharply falls to a minimum amplitude, and remains at the minimum amplitude for a time. Clocks 21 can be used by circuits of transmitter 12, such as by digital-to-analog converter(s) (DAC(s)). A DAC may be a circuit that converts a digital signal to an analog signal. An analog signal may be a signal that is continuous in time and represents some other quantity (referred to as amplitude or level of the signal). A digital signal may be a signal that is discrete in time and represents some other quantity as discrete values. Clocks 21 can be used by circuits of receiver 14, such as by analog-to-digital converter(s) (ADC(s)). An ADC may be a circuit that converts an analog signal to a digital signal. DACs and ADCs are just some example circuits and many other types of circuits can use multi-phase clock signals as generated by the embodiments and examples herein.

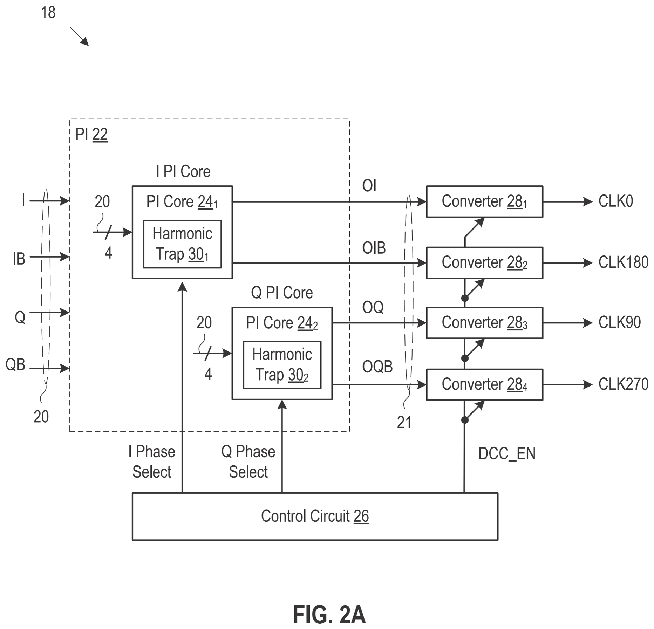

Fig. 2A is a block diagram depicting clock distribution circuit 18 according to some embodiments. An example application of clock distribution circuit 18 is shown in Fig. 1 and described above. It is to be understood that clock distribution circuit 18 can have various other applications with circuits that use multi-phase clock signals.

Clock distribution circuit 18 can include a phase interpolator (PI) 22, converters 28₁...28₄, and a control circuit 26. PI 22 can include an input to receive clock signals 20. Clock signals 20 can include an in-phase clock signal (I), a clock signal (IB) that is antiphase with the in-phase clock signal, a quadrature (Q) clock signal, and a clock signal (QB) that is antiphase with the quadrature clock signal. The I, Q, IB, and QB clock signals can have a common frequency and phases of (Φₒ + 0°), (Φₒ + 90°), (Φₒ + 180°), and (Φₒ + 270°), respectively, where Φₒ can be any arbitrary phase angle. PI 22 can include an input to supply clock signals 21. PI 22 can delay clock signals 20 by a selected phase angle to generate clock signals 21. PI 22 can output phase-delayed versions of clock signals I and IB, which are referred to as OI and OIB, respectively. PI 22 can output phase-delayed version of clock signals Q and QB, which are referred to as OQ and OQB, respectively. The OI, OQ, OIB, and OQB clock signals can have a common frequency and phases of (Φₒ + 0° + φ), (Φₒ + 90° + φ), (Φₒ + 180° + φ), and (Φₒ + 270° + φ), respectively, where φ can be the selected phase angle. A control circuit may be a circuit comprising digital logic configured to perform function(s). Digital logic may be circuitry that manipulates digital signals and can include logic gates, arithmetic logic units (ALUs), processors, memory, and the like or any combination thereof. Control circuit 26 can generate phase select signals for PI 22 to select the phase angle φ.

In some embodiments, PI 22 includes PI cores 24₁ and 24₂. Each of PI cores 24₁ and 24₂ can receive clock signals 20. PI core 24₁ can generate the OI and OIB clock signals as output. PI core 24₂ can generate the OQ and OQB clock signals as output. Thus, PI core 24₁ can be referred to as the in-phase (I) PI core and PI core 24₂ can be referred to as the quadrature (Q) PI core. PI 22 can be referred to as a quadrature PI. Control circuit 26 can provide I-phase select signals to PI core 24₁ and Q-phase select signals to PI core 24₂. PI core 24₁ can include a harmonic trap 30₁ and PI core 24₂ can include a harmonic trap 30₂. Other types of PIs known in the art can also be used with the techniques described herein. For example, a PI can include a single PI core that supplies two clock phases to a poly-phase filter, which in turn outputs four clock phases. Such a PI can include a harmonic trap in the single PI core. The function of harmonic traps in PI core(s) and embodiments thereof are described below.

As discussed above, clock signals 20 and 21 can be sinusoidal signals. In some embodiments, the circuitry coupled to clock distribution circuit 18 can use clock signals with square waveforms. Converters 28₁...28₄ may be circuits that convert sinusoidal input signals to square-wave output signals. Converters 28₁...28₄ can receive the OI, OIB, OQ, and OQB clock signals, respectively. Converters 28₁...28₄ can output square-wave clock signals CLK0, CLK180, CLK90, and CLK270, respectively.

In some embodiments, each of converters 28₁...28₄ can include a DCC control loop for compensating DCD. DCC control loops are discussed further below. As discussed above, operating a DCC control loop for each phase of multi-phase clock signals can be expensive in terms of power consumption and circuit area. Control circuit 26 can supply a DCC enable signal (DCC_EN) to each of converters 28₁...28₄. The DCC enable signal can be used to turn off the DCC control loop in each of converters 28₁...28₄. PI 22 can compensate for DCD using harmonic traps 30₁ and 30₂, as discussed further below. In other embodiments, converters 28₁...28₄ can omit circuits for DCC control loops. In such embodiments, control circuit 26 can omit the DCC enable signal.

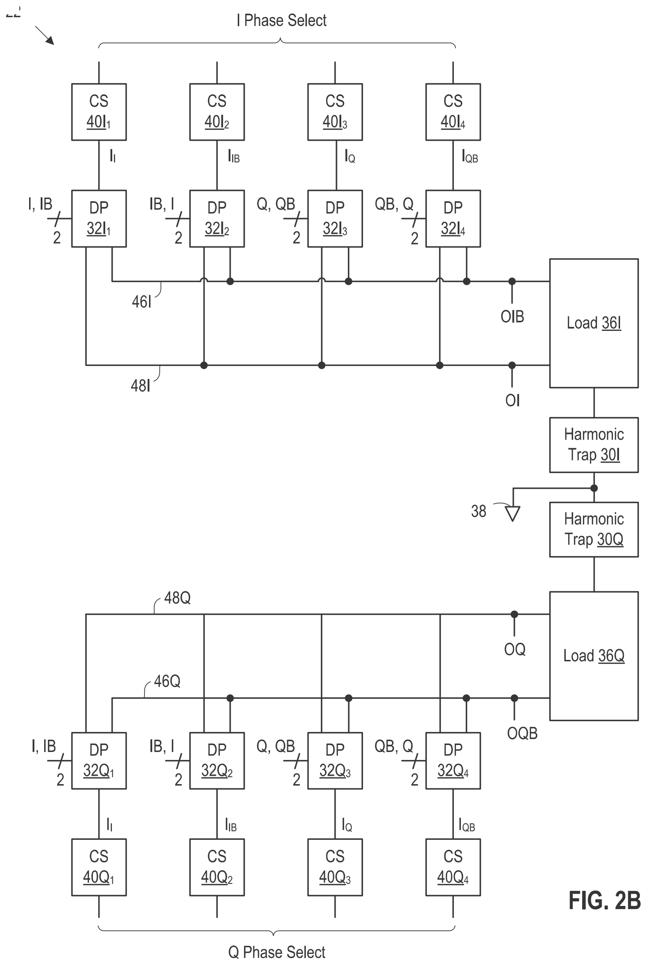

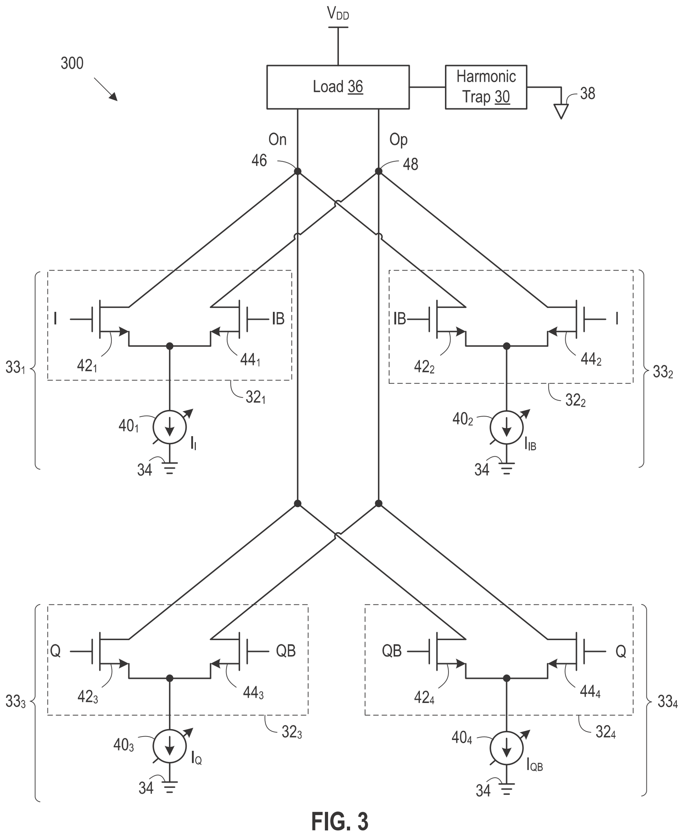

Fig. 2B is a block diagram depicting PI 22 according to some embodiments. Fig. 2B shows circuits of PI cores 24₁ and 24₂ according to some embodiments. Fig. 3 is a schematic diagram depicting a PI core 300 according to some embodiments. Each of PI core 24₁ and 24₂ can be implemented as shown for PI core 300. For clarity, Fig. 3 is discussed below before returning to Fig. 2A.

PI core 300 can include a circuit of transistors, current sources, a load 36, and a harmonic trap 30. The transistors can be field effect transistors (FETs). A FET can be a four-terminal device having gate, source, drain, and substrate terminals. Unless otherwise indicated, the transistors described herein have their substrate terminals coupled to their source terminals and, as such, the substrate terminals are not explicitly shown. FETs can be p-channel FETs or n-channel FETs, where n and p refer to the type of doping in the semiconductor material and the type of majority charge carrier, as is known in the art. Consistent with convention, any n-channel transistors are shown schematically with the source as an arrow facing away from the gate and any p-channel transistors are shown schematically with the source as an arrow facing towards the gate. There are many types of FETs known in the art. One skilled in the art can select among one or more such FETs based on the description of the examples and embodiments herein. Metal-oxide semiconductor field-effect transistors (MOSFETs) are widely used and well-known FETs in CMOS-based ICs. P-channel MOSFETs can be referred to as PMOS transistors and N-channel MOSFETs can be referred to as NMOS transistors. Accordingly, for purposes of clarity, various examples and embodiments are described below within the context of NMOS transistors, PMOS transistors, or a combination thereof.

PI core 300 can include differential transistor pairs 32₁...32₄. A transistor pair can be a first transistor coupled to a second transistor. For example, a source-coupled transistor pair can be a first transistor and a second transistor where the sources thereof are coupled. In some cases, the sources of the transistors in a source-coupled pair can be directly coupled. In other cases, the sources of the transistors in a source-coupled pair can be coupled through an impedance (sometimes referred to as a source degeneration impedance). A differential transistor pair can be a source-coupled transistor pair where the gates thereof receive a differential signal pair. A differential signal pair may be two signals that can be equal in amplitude and opposite in polarity (e.g., a first signal and a second signal that is antiphase with the first signal). One signal of the differential signal pair may be referred to as the positive signal and the other signal may be referred to as the negative signal. In some embodiments, differential transistor pair 33ₖ (k ∈ { 1, 2, 3, 4}) includes a transistor 42ₖ and a transistor 44ₖ. Each of transistor 42ₖ and 44ₖ can be an NMOS transistor. The source of transistor 42ₖ can be coupled to the source of transistor 44ₖ. The drain of transistor 42ₖ can be coupled to a node 46. The drain of transistor 44ₖ can be coupled to a node 48. A node may be a point in a circuit where two or more circuit elements are connected. A node can be shown in the drawings as a filled circle at a wire junction. Note that, for ease of illustration, a node may be shown as two or more separate junctions connected by only wire(s) and no circuit elements (e.g., a short-circuit connection). In such case, a reference numeral assigned to the node can be at one of the junctions or at one of the wires between the junctions, all of which collectively represent the node.

Differential transistor pair 32₁ can receive a differential signal pair comprising the I clock signal (positive signal) and the IB clock signal (negative signal). The I clock signal can be coupled to the gate of transistor 42₁ and the IB clock signal can be coupled to the gate of transistor 44₁. Differential transistor pair 32₂ can receive a differential signal pair comprising the IB clock signal (positive signal) and the I clock signal (negative signal). The IB clock signal can be coupled to the gate of transistor 42₂ and the I clock signal can be coupled to the gate of transistor 44₂. Differential transistor pair 32₃ can receive a differential signal pair comprising the Q clock signal (positive signal) and the QB clock signal (negative signal). The Q clock signal can be coupled to the gate of transistor 42₃ and the QB clock signal can be coupled to the gate of transistor 44₃. Differential transistor pair 32₄ can receive a differential signal pair comprising the QB clock signal (positive signal) and the Q clock signal (negative signal). The QB clock signal can be coupled to the gate of transistor 42₄ and the Q clock signal can be coupled to the gate of transistor 44₄. The I, IB, Q, and QB clock signals can be supplied by a clock generator (e.g., clock signals 20, Figs. 1, 2A).

PI core 300 can include current sources 40₁...40₄. A current source may be a circuit that supplies a current having a magnitude and direction. An independent current source may be a current source that is independent of voltage across the circuit, which is within a compliance voltage range (e.g., the minimum and maximum voltage the current source can supply to a load beyond which the circuit stops being an independent current source). Each of current sources 40₁...40₄ can be an independent current source. In addition, each of current sources 40₁...40₄ can be a weighted current source. A weighted current source can be a current source where the magnitude of the current has a selectable weight between a minimum weight and a maximum weight (e.g., the current can have a magnitude that is one of a plurality of discrete magnitudes). The weighted nature of the current sources is indicated in the drawing by an arrow passing diagonally through the current source symbol. The weighting of current sources 40₁...40₄ can be controlled by a control circuit (e.g., control circuit 26, Fig. 2A).

Current source 40₁ can be coupled between a ground 34 and a node formed by the sources of transistors 42₁ and 44₁. A ground may be a reference point in a circuit from which voltages in a circuit are measured. Ground 34 can be a direct current (DC) ground. A DC ground may be a ground that serves as a reference point for DC voltages in a circuit. Current source 40₁ can supply a current I₁. Current source 40₂ can be coupled between ground 34 and a node formed by the sources of transistors 42₂ and 44₂. Current source 40₂ can supply a current I_{IB}. Current source 40₃ can be coupled between ground 34 and a node formed by the sources of transistors 42₃ and 44₃. Current source 40₃ can supply a current I_{Q}. Current source 40₄ can be coupled between ground 34 and a node formed by the sources of transistors 42₄ and 44₄. Current source 40₄ can supply a current I_{QB}. The direction of currents I_{I}, I_{IB}, I_{Q}, and I_{QB} can be towards ground 34 (e.g., the current sources sink current from their respective differential transistors pairs).

The combination of a differential transistor pair and a current source as shown can be a transconductance circuit. A transconductance circuit may be a circuit that converts a voltage to a current. PI core 300 can include transconductance circuits 33₁...33₄. Transconductance circuit 33ₖ (k ∈ {1, 2, 3, 4}) can include differential transistor pair 32ₖ and current source 40ₖ.

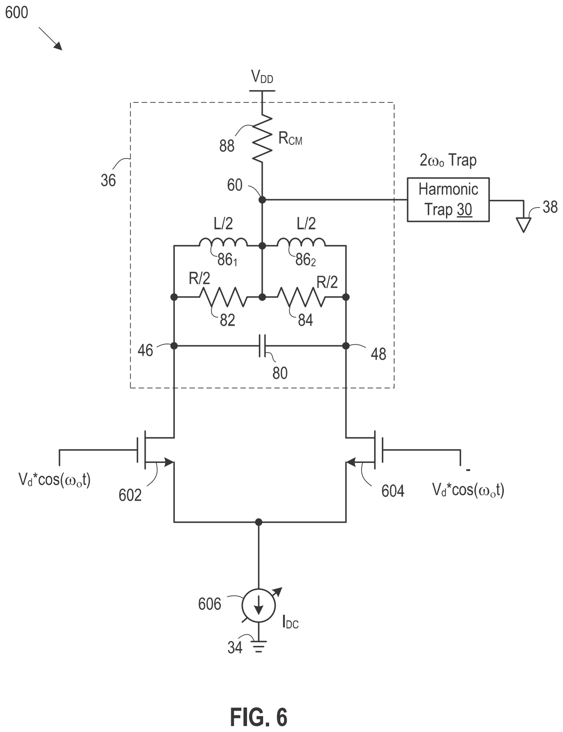

Load 36 can be coupled between a supply voltage (V_{DD}) and each of the nodes 46 and 48. Harmonic trap 30 can be coupled between load 36 and a ground 38. Ground 38 can be an alternating current (AC) ground. An AC ground may be a ground that serves as a reference point for AC voltages in a circuit. Load 36 can be a network of impedances. A network may be an interconnection of circuit components. An impedance may be a component that opposes current. Example impedances include resistors, capacitors, and inductors (as discrete circuit components). Some impedances can be part of or a property of a component (e.g., inter-terminal capacitance of a transistor). An embodiment of load 36 is shown in Fig. 6 and described below. In some embodiments, harmonic trap 30 can be a network of passive components. A passive component may be a component that requires external power to operate and cannot amplify signal power levels. Example passive components can include resistors, capacitors, and inductors. In contrast, an active component may be a component that requires external power to operate and can amplify signal power levels. An example active component can be a transistor. Embodiments of harmonic trap 30 are described below.

In operation, transconductance circuits 33₁...33₄ can draw current through load 36 in response to respective input differential signal pairs. Transconductance circuits 33₁...33₄ can combine to steer current between a first branch between load 36 and node 46 and a second branch between load 36 and node 48. Load 36 can convert the current into a differential voltage signal pair at nodes 46 and 48 (having a positive signal Op and a negative signal On). The voltage signal Op has a frequency in common with the input clock signals (I, IB, Q, QB) and a phase that is a vector sum of the phases of the input clock signals. The vector sum can be determined based on the weighting of current sources 40₁...40₄. The voltage signal On is antiphase with the voltage signal Op. PI core 300 can enable 0-360° phase rotation.

Returning to Fig. 2B, PI core 24₁ (e.g., I PI core) can include differential transistor pairs 33I₁...33I₄ (shown as DPs 33I₁...33I₄) and current sources 40I₁...40I₄ (shown as CSs 40I₁...40I₄). Differential transistor pairs 33I₁...33I₄ and current sources 40I₁...40I₄ can be instances of differential transistor pairs 33₁...33₄ and current sources 40₁...40₄, respectively, shown in Fig. 3. Differential transistor pair 32I₁ can receive a differential signal pair comprising the I clock signal (positive signal) and the IB clock signal (negative signal). Differential transistor pair 32I₂ can receive a differential signal pair comprising the IB clock signal (positive signal) and the I clock signal (negative signal). Differential transistor pair 32I₃ can receive a differential signal pair comprising the Q clock signal (positive signal) and the QB clock signal (negative signal). Differential transistor pair 32I₄ can receive a differential signal pair comprising the QB clock signal (positive signal) and the Q clock signal (negative signal). Current sources 40I₁...40I₄ can supply currents I_{I}, I_{IB}, I_{Q}, and I_{QB}, respectively. Weighting of current sources 40I₁...40I₄ can be controlled through an I phase select signal from control circuit 26. Outputs of differential transistors pairs 32I₁...32I₄ can be coupled to nodes 46I and 48I. A load circuit 36I can be coupled to nodes 46I and 48I. Node 46I can supply the clock signal OIB and node 48I can supply the clock signal OI.

PI core 24₂ (e.g., Q PI core) can include differential transistor pairs 33Q₁...33Q₄ (shown as DPs 33Q₁...33Q₄) and current sources 40Q₁...40Q₄ (shown as CSs 40Q₁...40Q₄). Differential transistor pairs 33Q₁...33Q₄ and current sources 40Q₁...40Q₄ can be instances of differential transistor pairs 33₁...33₄ and current sources 40₁...40₄, respectively, shown in Fig. 3. Differential transistor pair 32Q₁ can receive a differential signal pair comprising the I clock signal (positive signal) and the IB clock signal (negative signal). Differential transistor pair 32Q₂ can receive a differential signal pair comprising the IB clock signal (positive signal) and the I clock signal (negative signal). Differential transistor pair 32Q₃ can receive a differential signal pair comprising the Q clock signal (positive signal) and the QB clock signal (negative signal). Differential transistor pair 32Q₄ can receive a differential signal pair comprising the QB clock signal (positive signal) and the Q clock signal (negative signal). Current sources 40Q₁...40Q₄ can supply currents I_{I}, I_{IB}, I_{Q}, and I_{QB}, respectively. Weighting of current sources 40Q₁...40Q₄ can be controlled through a Q phase select signal from control circuit 26. Outputs of differential transistors pairs 32Q₁...32Q₄ can be coupled to nodes 46Q and 48Q. A load circuit 36Q can be coupled to nodes 46Q and 48Q. Node 46Q can supply the clock signal OQB and node 48Q can supply the clock signal OQ.

PI core 24₁ can include a harmonic trap 30I coupled between load 36I and ground 38. PI core 24₂ can include a harmonic trap 30Q coupled between load 36Q and ground 38. Harmonic traps 30I and 30Q can be instances of harmonic trap 30 shown in Fig. 3. As shown, harmonic traps 30I and 30Q can share a common AC ground, e.g., ground 38. Embodiments for implementing harmonic traps 30I and 30Q with a common AC ground are described below.

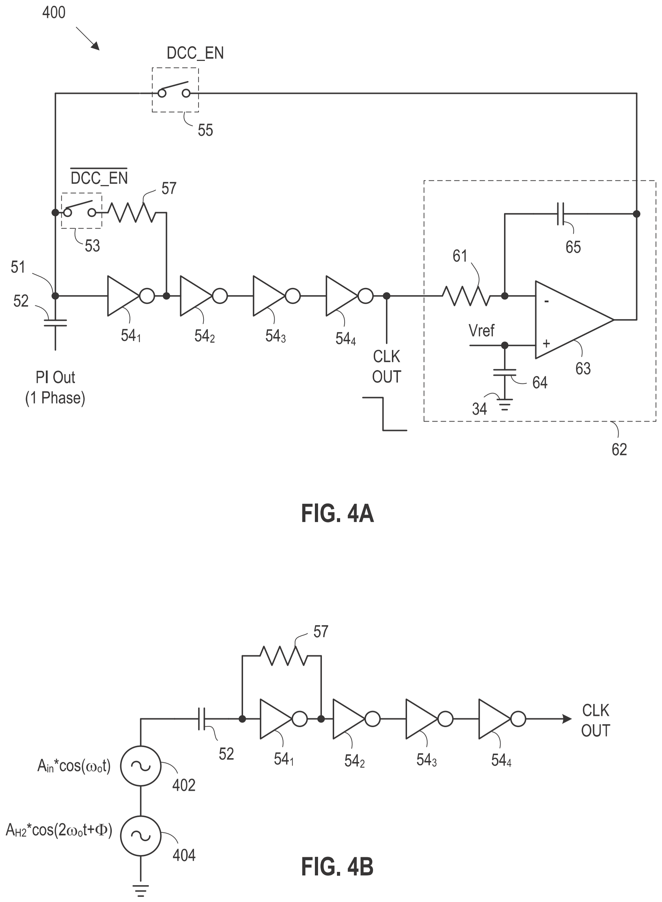

Fig. 4A is a schematic diagram depicting a converter 400 according to some embodiments. Each converter 28₁...28₄ can be implemented as shown for converter 400. Converter 400 includes a capacitor 42, inverters 54₁...54₄, switches 53 and 55, a resistor 57, and optionally DCC circuit 62. Capacitor 52 can be coupled between an input of converter 400 and a node 51. Inverters 54₁...54₄ can be coupled in series. Inverter 54₁ can be coupled between node 51 and an input of inverter 54₂. Inverter 54₂ can be coupled between inverters 54₁ and 54₃. Inverter 54₃ can be coupled between inverters 54₂ and 54₄. Inverter 54₄ can be coupled between inverter 54₃ and an input of DCC circuit 62. The output of DCC circuit 62 can be coupled to node 51 through switch 55. A series combination of switch 53 and resistor 57 can be coupled between node 51 and a node between inverters 54₁ and 54₂. Switches 53 and 55 can be single-pole, single-throw (SPST) switches. An SPST switch may be a circuit component that selectively connects two terminals based on a control input. SPST switches can be implemented using transistors, for example. The control input for switch 55 is the DCC enable signal (DCC_EN). The control input for switch 53 is the logical inverse of the DCC enable signal (shown as DCC_EN bar). A sinusoidal clock signal can be coupled to the input of converter 400 through capacitor 52 (e.g., one of the clock signals OI, OIB, OQ, and OQB). The node between the output of inverter 54₄ and the input of DCC circuit 62 can provide a clock signal with a square waveform as output. The number of inverters can be any even number (e.g., 2, 4, etc.). Each inverter 54₁...54₄ can be a CMOS logic circuit.

DCC circuit 62 can include a resistor 61, a capacitor 64, a capacitor 65, and an operational amplifier 63. The output of inverter 54₄ can be coupled to an inverting input of operational amplifier 63 through resistor 61. Capacitor 64 can be coupled between a non-inverting input of operational amplifier 63 and ground 34. Capacitor 65 can be coupled between the output and the inverting input of operational amplifier 63. The output of operational amplifier 63 can be the output of DCC circuit 62 (e.g., the output of operational amplifier 63 can be coupled to node 51 through switch 55).

When switch 55 closed (e.g., DCC_EN set to active), DCC circuit 62 can be connected to form a DCC loop. DCC circuit 62 functions as an error amplifier. However, as discussed above, more enabled DCC loops in the converters that are enabled results in increased power consumption. Thus, in embodiments, control circuit 26 can set the DCC enable signal to inactive, which can open switch 55 and disconnect DCC circuit 52 (e.g., no DCC loop). Switch 53 can be closed to connect resistor 57 and provide self-biasing for inverter 54₁. DCD can be compensated using harmonic trap(s) in the PI core(s), as discussed below. In some embodiments, DCC circuit 62 can be omitted from converter 400. In such an embodiment, switches 55 and 53 can also be omitted and resistor 57 can be coupled between the input and output of inverter 54₁. Such an embodiment can save circuit area in addition to reducing power consumption.

Fig. 4B is a schematic diagram depicting a model of converter 400 with distortion on the input clock signal. In Fig. 4B, assume DCC circuit 62 is disconnected (DCC_EN is inactive) or omitted. The input clock can be represented by an AC source having a waveform Aᵢₙ*cos(ωₒₜ), where Aᵢₙ is the amplitude (e.g., in millivolts), ωₒ is the angular frequency in radians/second, and t is an independent variable representing time. It has been observed that DCD can be contributed to by high-order, even-mode harmonics generated inside the PI. A harmonic of a sinusoidal signal with fundamental frequency may be a signal with a frequency that is an integer multiple of the fundamental frequency. A second harmonic may be a harmonic with a frequency of two times the fundamental frequency. In particular, the presence of a second harmonic can significantly change the duty cycle of the clock signal output from converter 400 (without compensation in the PI). This can be represented by an AC source superimposed on the input clock having a waveform A_{H2}*cos(2ωₒt + Φ), where A_{H2} is the amplitude (e.g., in millivolts) of the second harmonic, 2ωₒ is the angular frequency in radians/second, and Φ is an initial phase of the second harmonic.

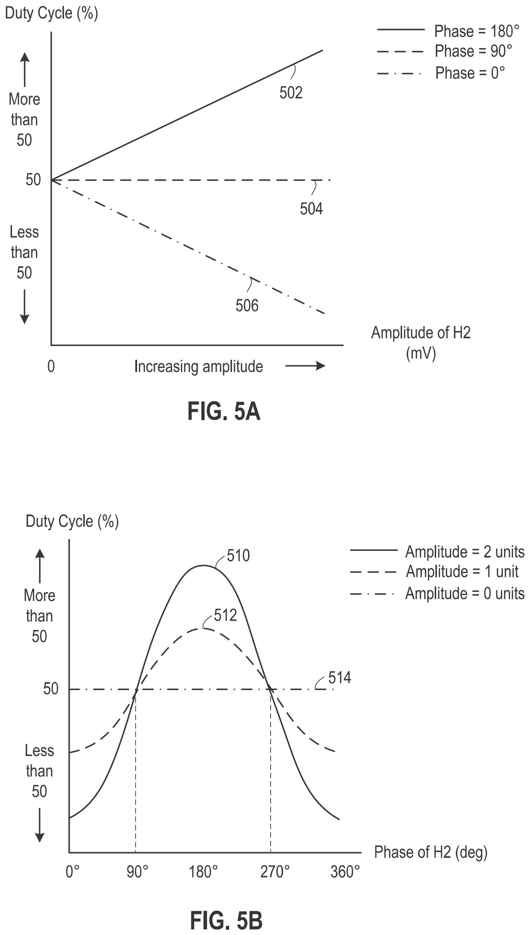

Fig. 5A is a graph depicting amplitude versus duty cycle for the clock signal output from converter 400 without DCD compensation. The graph includes a vertical axis representing duty cycle (as %) and a horizontal axis representing amplitude of the second harmonic (in mV). The graph is qualitative rather than quantitative. The amplitude H2 increases from zero going left to right. Duty-cycle percentage increases from 50 going upwards and decreases from 50 going downwards. A curve 502 can represent the relationship for an initial phase of 180° for the second harmonic. A curve 504 can represent the relationship for an initial phase of 90° for the second harmonic. A curve 506 can represent the relationship for an initial phase of 0° for the second harmonic. As can be seen from the graph, if the amplitude of the second harmonic is decreased, the output duty cycle improves (e.g., trends towards 50%). Also, if the second harmonic initial phase is 90° (or 270°) compared to the fundamental tone (e.g., the clock signal), the duty cycle dependence on the second harmonic also reduces.

Fig. 5B is a graph depicting phase versus duty cycle for the clock signal output from converter 400 without DCD compensation. The graph includes a vertical axis representing duty cycle (as %) and a horizontal axis representing initial phase of the second harmonic (in degrees). The graph is qualitative rather than quantitative. The amplitude H2 increases from zero going left to right. Duty-cycle percentage increases from 50 going upwards and decreases from 50 going downwards. A curve 510 can represent the relationship for a second harmonic amplitude of two units (e.g., a unit can be any amount of mV). A curve 512 can represent the relationship for a second harmonic amplitude of one unit. A curve 514 can represent the relationship for a second harmonic amplitude of zero units. Similar to the graph in Fig. 5A, as can be seen from the graph in Fig. 5B, if the amplitude of the second harmonic is decreased, the output duty cycle improves (e.g., trends towards 50%). Also, if the second harmonic initial phase is 90° (or 270°) compared to the fundamental tone (e.g., the clock signal), the duty cycle dependence on the second harmonic also reduces.

Fig. 6 is a schematic diagram depicting a model 600 of PI core 300 coupled to a load circuit and a harmonic trap according to embodiments. Model 600 can include a differential transistor pair comprising transistors 602 and 604 (e.g., NMOS transistors). The source of transistor 602 can be coupled to the source of transistor 604. Model 600 can include a current source 606 coupled between ground 34 and the sources of transistors 602 and 604. The drain of transistor 602 can be coupled to node 46 and the drain of transistor 604 can be coupled to node 48. Current source 602 can supply a current I_{DC}, which can be the sum of the currents supplied by current sources 40₁...40₄. The differential transistor pair can receive a differential signal pair denoted by V_{d}*cos(ωₒt) (positive signal) and -V_{d}*cos(ωₒt) (negative signal). The positive signal can be coupled to the gate of transistor 602 and the negative signal can be coupled to the gate of transistor 604.

Load circuit 36 can include a capacitor 80, resistors 82, 84, and 88, and an inductor 86. Capacitor 80 can be coupled between nodes 46 and 48. Resistors 82 and 84 can be coupled in series between nodes 46 and 48. Inductor 86 can be coupled between nodes 46 and 48. Resistor 88 can be coupled between the supply voltage (V_{DD}) and a node 60. Node 60 can include the junction between resistors 82 and 84 and a center terminal of inductor 86. The center terminal of an inductor can be a point where the inductance is divided in half. Thus, the center terminal at node 60 results in an inductor 86₁ between node 60 and node 46 and an inductor 86₂ between node 60 and node 48. If inductor 86 has an inductance of L, then each of inductors 86₁ and 86₂ can have an inductance of L/2. Each resistor 82 and 84 can have a resistance of R/2. Resistor 88 can have a resistance R_{CM}. In some embodiments, capacitor 80 can be a discrete capacitor. In other embodiments, capacitor 80 can represent parasitic capacitance as seen from the drains of differential transistor pair. In some embodiments, the resistors 82 and 84 can be the parasitic resistances of inductors 86₁ and 86₂, respectively.

As shown in Fig. 6, PI core 300 can be modeled by a differential transistor pair in large signal operation. Common-mode (CM) harmonic currents can be generated both at the tail node (e.g., the sources of the differential transistor pair) and at the output drain nodes. The CM harmonic current can cause a CM voltage swing at the output after passing through resistor 88. In the presence of a common-mode voltage shifting resistance at the output (e.g., resistor 88), the amplitude of the second harmonic voltage increases further. In a typical implementation, R_{CM} can be large enough to be the dominant contributor to the output second harmonic voltage. Consider the effect of input clock amplitude on the PI core output waveforms. A larger input amplitude can increase the CM swing by introducing a larger even-harmonic current due to transistor operation (e.g., switching between saturation and triode region). The large CM variation can worsen the output duty cycle. The presence of a mismatch/imbalance in the input clock can increase the value of the second harmonic even further.

In some embodiments, harmonic trap 30 can be coupled between node 60 and ground 38. A harmonic trap may be a circuit that provides a low-impedance path for an AC signal at a selected frequency, where the AC signal can be a harmonic of a fundamental signal. Harmonic trap 30 can be tuned to the second harmonic frequency 2ωₒ. A harmonic mitigation approach can improve the PI core output duty cycle significantly and compensate for DCD. The harmonic mitigation approach can remote the need of an error amplifier-based DCC circuit for each output clock signal. Elimination of the error amplifier-based DCC circuit can eliminate noise amplification and residual duty cycle error from the error amplifier input mismatch. Further, in some embodiments, harmonic trap 30 can be a network of passive components. Thus, harmonic mitigation can be achieved without introducing additional power consumption and with low impact on circuit area. Harmonic trap 30 can provide a low impedance in the CM path at the second harmonic frequency. The least intrusive location to trap the second harmonic current can be at node 60. Harmonic trap 30 can include a DC block so that either the voltage supply (V_{DD}) or ground 34 can be used as an AC ground based on physical proximity. Various embodiments of harmonic trap 30 are described below.

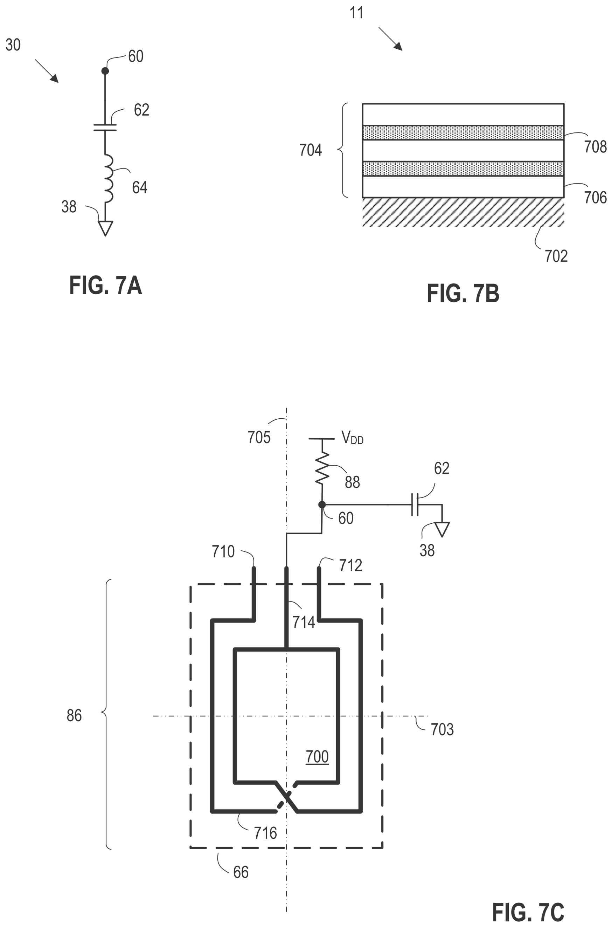

Fig. 7A is a schematic diagram depicting harmonic trap 30 according to some embodiments. Harmonic trap 30 can include a capacitor 62. Inductor 64 in series with capacitor 62 can model the parasitic inductance of terminals of capacitor 62. Thus, in some embodiments, harmonic trap 30 can be a shunt capacitor. The capacitance of capacitor 62 can be set to add a low-impedance path at a frequency of 2ωₒ with a phase shit of -90°. Capacitor 62 can sink the second harmonic current and minimize the second harmonic current at the output of the PI core. Capacitor 62 can have no effect on the differential swing at the output. The parasitic inductance inductor 64 of capacitor 62 can determine its self-resonance frequency (SRF). At the operating frequency, capacitor 62 can operate below its SRF. The parasitic inductance is omitted from subsequent drawings and description for purposes of clarity.

Fig. 7B is a side view of IC 11 according to some embodiments. IC 11 can include conductive interconnect 704 disposed on a semiconductor substrate 702. The circuitry of IC 11 can be formed in semiconductor substrate 702 and conductive interconnect 704. Conductive interconnect 704 can include layers 706 and 708. Layers 706 can be patterned metal to form conductors. Layers 708 can be dielectric material. Vias (not shown) can be formed in layers 708 to implement inter-layer electrical connections between conductors on different layers 706. Load circuit 36 and harmonic trap 30 can be formed in conductive interconnect 704 using one or more layers 706.

Fig. 7C is a hybrid physical layout and schematic view of load circuit 36 and harmonic trap 30 according to some embodiments. The physical layout of inductor 86 in load circuit 36 is shown from a top-down perspective. Inductor 86 can be formed using one or more layers 706 of conductive interconnect 704. In some embodiments, inductor 86 can be implemented as a two-turn inductor structure with a center terminal. Inductor 86 can include a coil 716 with two end terminals 710, 712 and a center terminal 714. End terminals 710, 712 of coil 714 can be coupled to nodes 46 and 48, respectively, of the output of the PI core. Center terminal 714 can be coupled to node 60 of load circuit 36. Coil 716 can be symmetrical about a vertical center line 705. Coil 716 can include a center area 700 that is devoid of any conductors of coil 716. Vertical center line 705 can divide center area 700 in half into left and right portions. A horizontal center line 703 can divide center area 700 in half into top and bottom portions. Coil 716, center terminal 714, and end terminals 710, 712 of inductor 86 are electrically connected and represent one continuous area or segment of conductive material. Coil 716 can be implemented within one or more layers 706 of conductive interconnect of IC 704.

In embodiments, coil 716 of inductor 86 can be implemented as a symmetrical two-turn rectangular coil. In other embodiments, coil 716 of inductor 86 can include more than two turns. In other embodiments, coil 716 of inductor 86 can have other shapes than rectangular that are allowable by an IC manufacturing process. Thus, the implementation of inductor 86 as a two-turn rectangular coil is shown for clarity and descriptive purposes and is not intended to be limiting.

Coil 716 of inductor 86 can be surrounded by a shield 66. Shield 66 can be coupled to a ground (e.g., ground 34). Shield 66 can be formed on the same layer(s) 706 of conductive interconnect 704 as coil 716 or on a different layer 706. Although shown as a continuous rectangle, shield 66 can have other shapes, including other shapes that conform to the shape of coil 716. In addition, shield 66 can have a break in continuity so that shield 66 is not a continuous ring.

As shown schematically, capacitor 62 of harmonic trap 30 can be coupled between node 60 (e.g., center terminal 714) and ground 38 (e.g., an AC ground). Resistor 88 can be coupled between node 60 (center terminal 714) and the supply voltage (V_{DD}). Embodiments for physical implementation of capacitor 62 are described below.

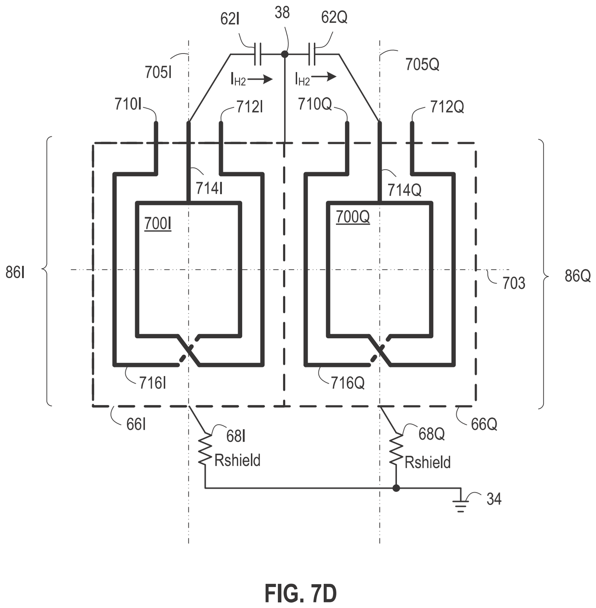

Fig. 7D is a hybrid physical layout and schematic view of load circuits 36I and 36Q and harmonic traps 30I and 30Q of PI 22 according to some embodiments. Elements of load circuits 36I and 36Q, as well as harmonic traps 30I and 30Q, are designated with identical reference numerals as load circuit 36 and harmonic trap 30, with the addition of "I" and "Q" to distinguish between PI core 24₁ (the I PI core) and PI core 24₂ (the Q PI core). The designation "I" in the reference character indicates that the element is part of PI core 24₁. The designation "Q" in the reference character indicates that the element is part of PI core 24₂.

Load circuit 36I can include an inductor 86I and load circuit 36Q can include an inductor 86Q. Each of load circuits 36I and 36Q can be implemented as shown in Fig. 6. Each of inductors 86I and 86Q can be implemented as shown for inductor 86 in Figs. 6 and 7C. Coil 716I of inductor 86I can have a center area 700I. Coil 716I can be symmetrical about vertical center line 705I. Coil 716Q of inductor 86Q can have a center area 700Q. Coil 716Q can be symmetrical about vertical center line 706Q. Coils 716I, 716Q can be disposed adjacent to one another and can be formed using the same layer(s) 706 of conductive interconnect 704 or different layers 706. Shield 66I can surround coil 716I. Shield 66Q can surround coil 716Q. In some embodiments, shields 66I and 66Q can share a common side between coils 716I and 716Q. Shields 66I, 66Q can be coupled to ground 36. Resistors 68I and 66Q can model the resistance of the connection between shields 66I and 66Q and ground 34 (Rshield). Center areas 700I and 700Q can be divided in half by center line 703. Harmonic trap 30I includes a capacitor 62I and harmonic trap 30Q includes a capacitor 62Q. Capacitor 62I is coupled between center terminal 714I and shield 66I. Capacitor 62Q is coupled between center terminal 714Q and shield 66Q. Shields 66I and 66Q can serve as AC ground 38.

Since the I/Q phase difference of the clock signals is 90°, the I/Q phase difference of the second harmonic currents is 180°. The antiphase relation of the second harmonic currents in PI core 24₁ and the PI core 24₂ can allow shields 66I, 66Q to be used as a virtual ground for the second harmonic currents (e.g., the ground is virtual in that Rshield is present between shields 66I, 66Q and ground 34). Shields 66I, 66Q can be a self-contained system for the second harmonic current. Capacitor 62I can conduct second harmonic current I_{H2} from center terminal 714I towards shield 66I and capacitor 62Q can conduct second harmonic current I_{H2} from shield 66Q towards center terminal 714Q. The net current from shields 66I, 66Q to ground 34 through Rshield can be at or near zero.

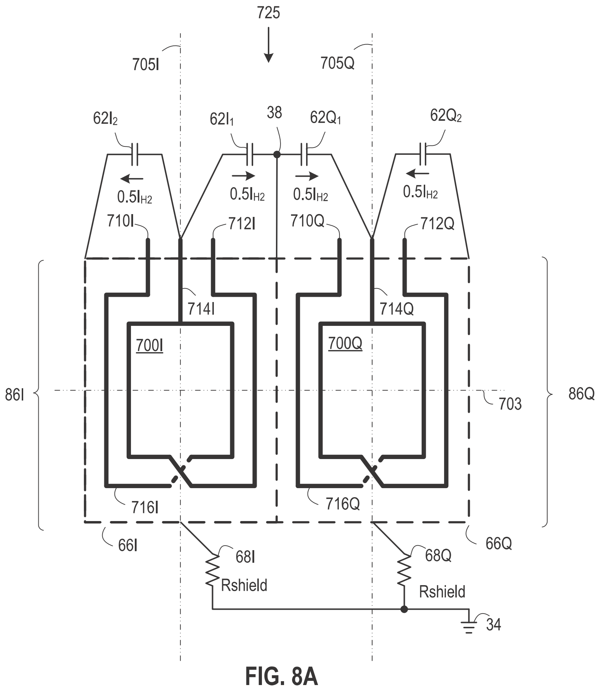

Fig. 8A is a hybrid physical layout and schematic view of load circuits 36I and 36Q and harmonic traps 30I and 30Q of PI 22 according to further embodiments. Elements of Fig. 8A that are the same or similar to those of Fig. 7D are illustrated similarly and designated with identical reference numerals. The difference between the implementation in Fig. 8A and Fig. 7D is that the capacitors 62I and 62Q can be split in half. That is, capacitor 62I can be split into capacitors 62I₁ and 62I₂ each having the same capacitance (e.g., half the capacitance of capacitor 62I). Likewise, capacitor 62Q can be spilt into capacitors 62Q₁ and 62Q₂ each having the same capacitance. Capacitor 62I₁ can be coupled between center terminal 714I and shield 66I and can conduct current 0.5*I_{H2} from center terminal 714I towards shield 66I. Capacitor 62I₂ can be coupled between center terminal 714I and shield 66I and can conduct current 0.5*I_{H2} from center terminal 714I towards shield 66I. Capacitors 62I₁ and 62I₂ can be coupled to different portions of shield 66I. Likewise, capacitor 62Q₁ can be coupled between center terminal 714Q and shield 66Q and can conduct current 0.5*I_{H2} from shield 66Q towards center terminal 714Q. Capacitor 62Q₂ can be coupled between center terminal 714Q and shield 66Q and can conduct current 0.5*I_{H2} from shield 66Q towards center terminal 714Q. Capacitors 62Q₁ and 62Q₂ can be coupled to different portions of shield 66Q.

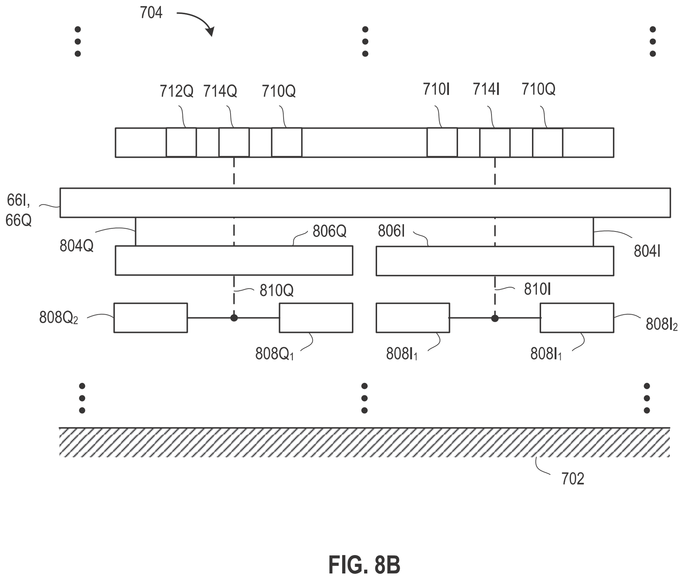

Fig. 8B is a side view of the physical layout shown in Fig. 8A according to some embodiments. The physical layout shows conductive interconnect 704 of IC 11 disposed on a substrate 702 of IC 11 and looking in a direction 725 (Fig. 8A). In the example, four layers of the conductive interconnect 704 are shown. The four layers can be any four layers of a multi-layer conductive interconnect, which can include more than four layers. A first layer includes coils 716I, 716Q of inductors 86I and 86Q, respectively. The terminals 712Q, 714Q, 710Q, 712I, 714I, and 710I are shown. A second layer below the first layer includes shields 66I, 66Q. A third layer below the second layer includes a first plate of each of capacitors 62I₁, 62I₂, 62Q₁, and 62Q₂. A conductor 806Q can implement the first plate of each of capacitors 62Q₁ and 62Q₂. Since the first plates of capacitors 62Q₁ and 62Q₂ are electrically connected (Fig. 8A), a single conductor 806Q can be used to implement both plates. Likewise, a conductor 806I can implement the first plate of each of capacitors 62I₁ and 62I₂. Since the first plates of capacitors 62I₁ and 62I₂ are electrically connected (Fig. 8A), a single conductor 806I can be used to implement both plates. A fourth layer below the third layer includes second plates of each of capacitors 62I₁, 62I₂, 62Q₁, and 62Q₂. A conductor 808Q₁ can implement the second plate of capacitor 62Q₁. A conductor 808Q₂ can implement the second plate of capacitor 62Q₂. Likewise, a conductor 808I₁ can implement the second plate of capacitor 62I₁. A conductor 808I₂ can implement the second plate of capacitor 62I₂. One or more vias 804Q can electrically connect conductor 806Q and shield 66Q. One or more vias 804I can electrically connect conductor 806I and shield 66I. One or more vias and conductors 810Q can electrically connect center terminal 714Q and conductors 802Q₁ and 802Q₂. One or more vias and conductors 810I can electrically connect center terminal 714I and conductors 802I₁ and 802I₂. Thus, capacitors 62I₁, 62I₂, 62Q₁, and 62Q₂ can be disposed underneath shield 66 to avoid area overhead.

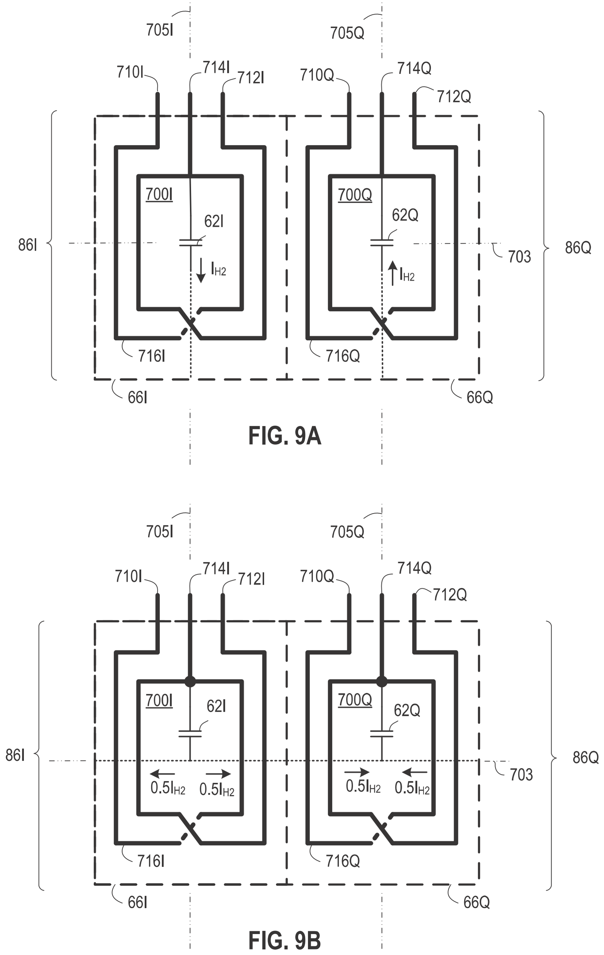

Fig. 9A is a hybrid physical layout and schematic view of load circuits 36I and 36Q and harmonic traps 30I and 30Q of PI 22 according to further embodiments. Elements of Fig. 9A that are the same or similar to those of Fig. 7D are illustrated similarly and designated with identical reference numerals. Inductors 86I and 86Q can exhibit minimal flux coupling at the center of areas 700I and 700Q, respectively (e.g., the intersection of vertical center line 705I and horizontal center line 703, and the intersection of vertical center line 705Q and horizontal center line 703). In some embodiments, capacitor 62I can be disposed at or near the center of area 700I. Capacitor 62Q can be disposed at or near the center of area 700Q. Such a placement for capacitors 62I and 62Q can exhibit minimal interaction with inductors 86I and 86Q, respectively. In order to avoid any systematic error and ensure symmetric differential operation, the connection to shields 66I, 66Q for capacitors 62I and 62Q can be symmetrical. In the embodiment of Fig. 9A, capacitor 62I can be coupled to the side of shield 66I that is perpendicular to vertical center line 705I and opposite the side nearest center terminal 714I. Likewise, capacitor 62Q can be coupled to the side of shield 66Q that is perpendicular to vertical center line 705Q opposite the side nearest center terminal 714Q.

Fig. 9B is a hybrid physical layout and schematic view of load circuits 36I and 36Q and harmonic traps 30I and 30Q of PI 22 according to further embodiments. Fig. 9B is similar to Fig. 9A, but with a different implementation of the connections between capacitors 62I and 62Q and shield 66. In the embodiment of Fig. 9B, capacitor 62I can be coupled to both of the sides of shield 66I that are parallel to vertical center line 705I. The connection between capacitor 62I and shield 66I can be at or near horizontal center line 703. Likewise, capacitor 62Q can be coupled to both of the sides of shield 66Q that are parallel to vertical center line 705I. The connection between capacitor 62I and shield 66Q can be at or near horizontal center line 703.

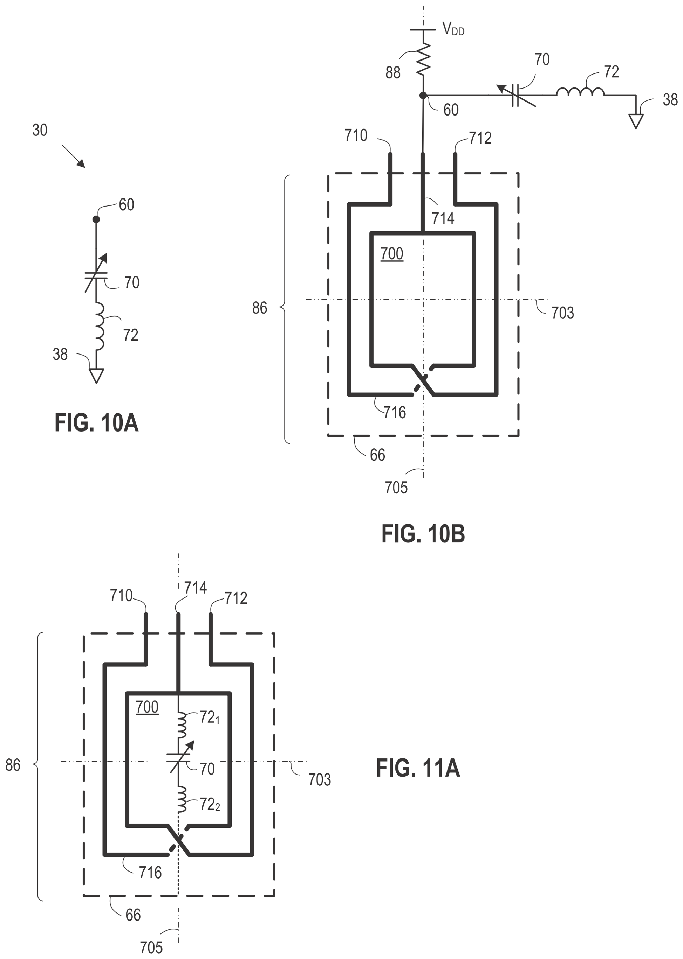

Fig. 10A is a schematic diagram depicting harmonic trap 30 according to further embodiments. Harmonic trap 30 can include a capacitor 70 in series with an inductor 72 (e.g., an LC tank circuit). Unlike the embodiment of Fig. 7A, the present embodiment can employ an explicit inductor in series with the capacitor. The addition of inductor 72 can add an additional degree of freedom to select capacitor 70 independent of the parasitic lead inductance of capacitor 70. Thus, capacitor 70 can have a smaller capacitance than capacitor 62. In some embodiments, capacitor 70 can be programmable to enable second harmonic tuning over a frequency range. The LC tank of capacitor 70 and inductor 72 can be set to add a low-impedance path at a frequency of 2ωₒ with a phase shit of 0°. The LC tank can sink the second harmonic current and minimize the second harmonic current at the output of the PI core. The LC tank can have no effect on the differential swing at the output.

Fig. 10B is a hybrid physical layout and schematic view of load circuit 36 and harmonic trap 30 according to further embodiments. Elements of Fig. 10B that are the same or similar to those of Fig. 7C are designated with identical reference numerals. The difference between the embodiment of Fig. 7C and the embodiment of Fig. 10B is the implementation of harmonic trap 30, which is the LC tank comprising capacitor 70 and inductor 72 in the embodiment of Fig. 10B. Otherwise, the description of Fig. 7C applies to Fig. 10B.

Fig. 11A is a hybrid physical layout and schematic view of load circuit 36 and harmonic trap 30 according to further embodiments. Fig. 11A is similar to Fig. 10B other than showing the placement of the LC tank. In some embodiments, the LC tank of harmonic trap 30 can be located at or near the center of center area 700 (e.g., at or near the junction of vertical center line 705 and horizontal center line 703). Inductor 72 can be split into two halves, e.g., inductor 72₁ and inductor 72₂. Capacitor 70 can be coupled in series with inductors 72₁ and 72₂. The LC tank can be coupled to shield 66, e.g., the side of shield 66 perpendicular to vertical center line 705 and opposite the side nearest center terminal 714.

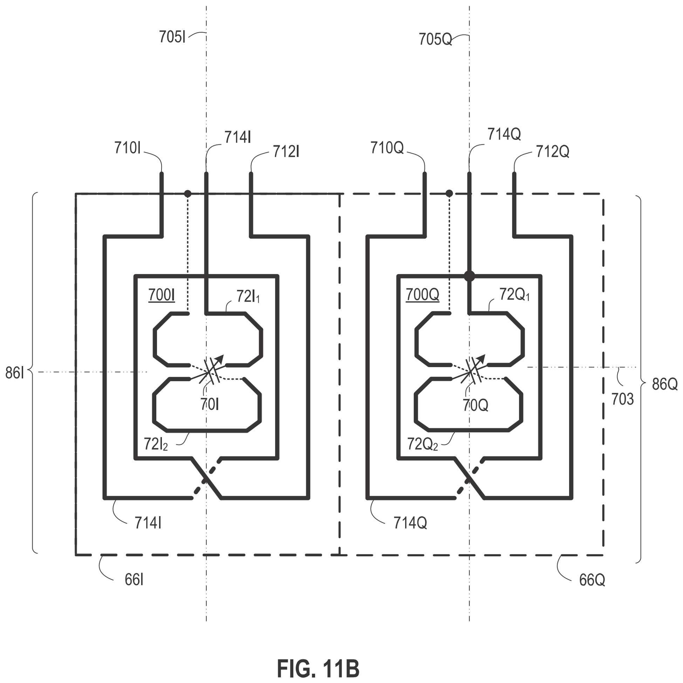

Fig. 11B is a hybrid physical layout and schematic view of load circuits 36I and 36Q and harmonic traps 30I and 30Q of PI 22 according to further embodiments. Elements of Fig. 11B that are the same or similar to those of Fig. 9A are illustrated similarly and designated with identical reference numerals. Inductors 86I and 86Q can exhibit minimal flux coupling at the center of areas 700I and 700Q, respectively (e.g., the intersection of vertical center line 705I and horizontal center line 703, and the intersection of vertical center line 705Q and horizontal center line 703). In some embodiments, harmonic trap 30I can include capacitor 70I and inductor 72I. Inductor 721 can be implemented using coils in a figure-8 pattern disposed at or near the center of center area 700I. Capacitor 70I can be coupled between coils for inductors 72I₁ and 72I₂. One end of the coil for inductor 72I₁ can be coupled to center terminal 714I. The other end of the coil for inductor 72I₁ can be coupled to shield 66I (e.g., the side of shield 66I perpendicular to vertical center line 705I and near center terminal 714I). Likewise, harmonic trap 30Q can include capacitor 70Q and inductor 72Q. Inductor 72Q can be implemented using coils in a figure-8 pattern disposed at or near the center of center area 700Q. Capacitor 70Q can be coupled between coils for inductors 72Q₁ and 72Q₂. One end of the coil for inductor 72Q₁ can be coupled to center terminal 714Q. The other end of the coil for inductor 72Q₁ can be coupled to shield 66Q (e.g., the side of shield 66Q perpendicular to vertical center line 705Q and near center terminal 714Q).

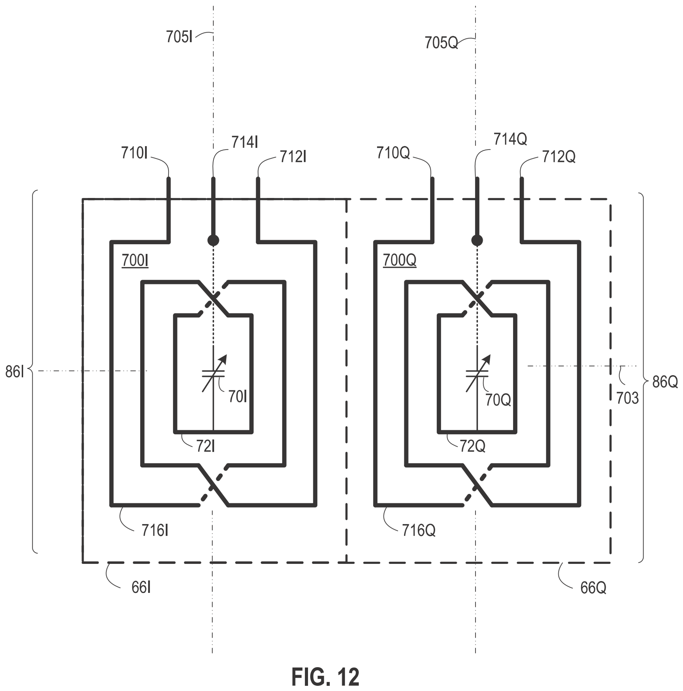

Fig. 12 is a hybrid physical layout and schematic view of load circuits 36I and 36Q and harmonic traps 30I and 30Q of PI 22 according to further embodiments. Elements of Fig. 12 that are the same or similar to those of Fig. 11B are illustrated similarly and designated with identical reference numerals. In the embodiment of Fig. 12, the figure-8 pattern of inductors 72I and 72Q can be replaced with an odd-turn coil. Capacitor 70I can be coupled to the center of the odd-turn coil of inductor 72I. Capacitor 70Q can be coupled to the center of the odd-turn coil of inductor 72Q.

While some processes and methods having various operations have been described, one or more embodiments also relate to a device or an apparatus for performing these operations. The apparatus may be specially constructed for required purposes, or the apparatus may be a general-purpose computer selectively activated or configured by a computer program stored in the computer. Various general-purpose machines may be used with computer programs written in accordance with the teachings herein, or it may be more convenient to construct a more specialized apparatus to perform the required operations.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C ," or alternatively, "at least one of A, at least one of B, and at least one of C," it is expressly described as such.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

As used herein, the term "couple" and its derivatives include: (a) electrical, magnetic, and communicative coupling; and (b) do not imply a direct connection, but rather may include intervening elements, unless described as "directly coupled."

Although one or more embodiments of the present invention have been described in some detail for clarity of understanding, certain changes may be made within the scope of the claims. Accordingly, the described embodiments are to be considered as illustrative and not restrictive, and the scope of the claims is not to be limited to details given herein but may be modified within the scope and equivalents of the claims. In the claims, elements and/or steps do not imply any particular order of operation unless explicitly stated in the claims.

Boundaries between components, operations, and data stores are somewhat arbitrary, and particular operations are illustrated in the context of specific illustrative configurations. Other allocations of functionality are envisioned and may fall within the scope of the invention. In general, structures and functionalities presented as separate components in exemplary configurations may be implemented as a combined structure or component. Similarly, structures and functionalities presented as a single component may be implemented as separate components. These and other variations, additions, and improvements may fall within the scope of the appended claims.

## Claims

1. A phase interpolator in an integrated circuit, IC, comprising:
a first circuit including a transistor pair and a current source, the transistor pair including a first transistor coupled between a first node and the current source, and second transistor coupled between a second node and the current source, a gate of the first transistor configured to receive a first clock signal and a gate of the second transistor configured to receive a second clock signal that is antiphase with the first clock signal;
a load circuit including a first inductor coupled between the first node and the second node and a resistor coupled between a voltage source and a center terminal of the first inductor; and
a second circuit coupled between the center terminal of the first inductor and an alternating current, AC, ground, the second circuit tuned to conduct a second harmonic of the first clock signal.

2. The phase interpolator of claim 1, further comprising:
a shield around the first inductor;
wherein the second circuit is coupled between the center terminal of the first inductor and the shield.

3. The phase interpolator of claim 2, wherein
the second circuit comprises a capacitor.

4. The phase interpolator of claim 3, wherein
the first inductor is disposed on a first layer of conductive interconnect of the IC, and wherein
the capacitor is disposed on a second layer of the conductive interconnect, the second layer being above or below the first layer.

5. The phase interpolator of claim 3, wherein
the first inductor comprises coils in conductive interconnect of the IC, and wherein
the capacitor is disposed in the conductive interconnect in an area inside the coils.

6. The phase interpolator of claim 2, wherein
the second circuit comprises a capacitor in series with a second inductor, the series of the capacitor and the second inductor coupled between the center terminal of the first inductor and the shield;
wherein in particular
the first inductor comprises coils in conductive interconnect of the IC, and
the capacitor and the second inductor are disposed in the conductive interconnect in an area inside the coils.

7. A phase interpolator in an integrated circuit, IC, comprising:
a first current source and a second current source;
a first transistor pair including a first transistor coupled between a first node and the first current source, and a second transistor coupled between a second node and the first current source, the first transistor pair configured to output a first clock signal at the first node and a second clock signal at the second node, the second clock signal being antiphase with the first clock signal;
a second transistor pair including a third transistor coupled between a third node and the second current source, and a fourth transistor coupled between a fourth node and the second current source, the second transistor pair configured to output a third clock signal, which is in quadrature with the first clock signal, at the third node and a fourth clock signal at the fourth node, the fourth clock signal being antiphase with the third clock signal;
a first inductor coupled between the first and second nodes and a second inductor coupled between the third and fourth nodes;
a first resistor coupled between a voltage source a center terminal of the first inductor and a second resistor coupled between the voltage source and a center terminal of the second inductor;
a first network coupled between the center terminal of the first inductor and an alternating current, AC, ground; and
a second network coupled between the center terminal of the second inductor and the AC ground.

8. The phase interpolator of claim 7, further comprising:
a shield around the first inductor and the second inductor;
wherein the AC ground is the shield.

9. The phase interpolator of claim 8, wherein
the first network comprises a first capacitor and the second network comprises a second capacitor.

10. The phase interpolator of claim 9, wherein
the first inductor and the second inductor are disposed on a first layer of conductive interconnect of the IC, and wherein the first capacitor and the second capacitor are disposed on a second layer of the conductive interconnect, the second layer being above or below the first layer.

11. The phase interpolator of claim 9, wherein
the first inductor comprises first coils in conductive interconnect of the IC, wherein the second inductor comprises second coils in the conductive interconnect, wherein the first capacitor is disposed in the conductive interconnect in an area inside the first coils, and wherein the second capacitor is disposed in the conductive interconnect in an area inside the second coils.

12. The phase interpolator of claim 8, wherein
the first network comprises a first capacitor in series with a third inductor, the series of the first capacitor and the third inductor coupled between the center terminal of the first inductor and the shield, and wherein the second network comprises a second capacitor in series with a fourth inductor, the series of the second capacitor and the fourth inductor coupled between the center terminal of the second inductor and the shield.

13. The phase interpolator of claim 12, wherein
the first inductor comprises first coils in conductive interconnect of the IC, wherein the second inductor comprises second coils in conductive interconnect of the IC, wherein the first capacitor and the third inductor are disposed in the conductive interconnect in an area inside the first coils, and wherein the second capacitor and the fourth inductor are disposed in the conductive interconnect in an area inside the second coils;
wherein in particular
each of the third inductor and the fourth inductor comprises a figure-8 coil.

14. A clock distribution circuit in an integrated circuit, IC, comprising:
a phase interpolator as set forth in any one of the preceding claims 1 to 6;
a third circuit coupled to the first node, the third circuit including a first series of inverters, a second resistor coupled between an input and an output of a first inverter in the first series; and
a fourth circuit coupled to the second node, the fourth circuit including a second series of inverters, a third resistor coupled between an input and an output of a second inverter in the second series.

15. The clock distribution circuit of claim 14, further comprising
a clock generator configured to supply the first clock signal and the second clock signal.
